# EUROPÄISCHE PATENTSCHRIFT

(11) **EP 2 162 912 B1**
(45) Veröffentlichungstag und Bekanntmachung des Hinweises auf die Patenterteilung: **04.12.2019**
(21) Anmeldenummer: 08801466.7
(22) Anmeldetag: 16.06.2008
(51) Int. Cl.: H01L 23/482

(54) **HALBLEITERBAUELEMENT MIT RINGFÖRMIG GESCHLOSSENER KONTAKTIERUNG**
SEMI-CONDUCTOR COMPONENT HAVING A RING-SHAPED CLOSED CONTACT
COMPOSANT SEMICONDUCTEUR À MISE EN CONTACT FERMÉE EN FORME D'ANNEAU

(30) Priorität: 18.06.2007 DE 102007028458
(43) Veröffentlichungstag der Anmeldung: 17.03.2010
(73) Patentinhaber: AZUR SPACE Solar Power GmbH, 74072 Heilbronn (DE); Institut für Mikroelektronik Stuttgart, 70569 Stuttgart (DE)
(72) Erfinder: DAUMILLER, Ingo, 89165 Dietenheim/Regglisweiler (DE); SÖNMEZ, Ertugrul, 89075 Ulm (DE); KUNZE, Mike, 89284 Pfaffenhofen (DE)
(74) Vertreter: Witte, Weller & Partner Patentanwälte mbB
(86) Internationale Anmeldenummer: PCT/EP2008/004839
(87) Internationale Veröffentlichungsnummer: WO 2008/155086

(56) Entgegenhaltungen:
- EP-A- 0 845 815
- WO-A-99/21231
- DE-A1- 19 541 497
- DE-C1- 19 705 791
- US-A- 4 058 822
- US-A- 4 290 077
- US-A1- 2007 278 614

## Beschreibung

Die Erfindung betrifft ein Halbleiterbauelement, durch welches bei einer kleinen Oberfläche große Ströme mit geringem Widerstand leitbar sind. Die Erfindung betrifft außerdem ein Verfahren zur Herstellung eines Halbleiterbauelementes, wobei vorzugsweise ein erfindungsgemäßes Halbleiterbauelement hergestellt wird.

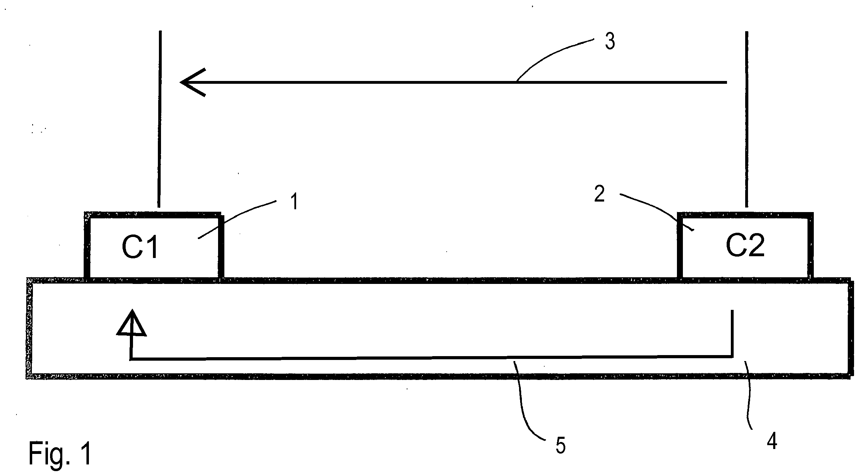

Figur 1 zeigt ein Halbleiterbauelement nach dem Stand der Technik. Hierbei sind zwei Elektroden 1 und 2 auf einem Substrat 4 angeordnet. Wird zwischen die Elektroden 1 und 2 eine Spannung 3 angelegt, so fließt durch das Substrat 4 ein Strom 5. Der Strom 5 fließt hierbei lateral von der Elektrode 2 zur Elektrode 1 parallel zur Substratoberfläche. Das Substrat 4 ist hier eine leitfähige Schicht bzw. ein Halbleiter.

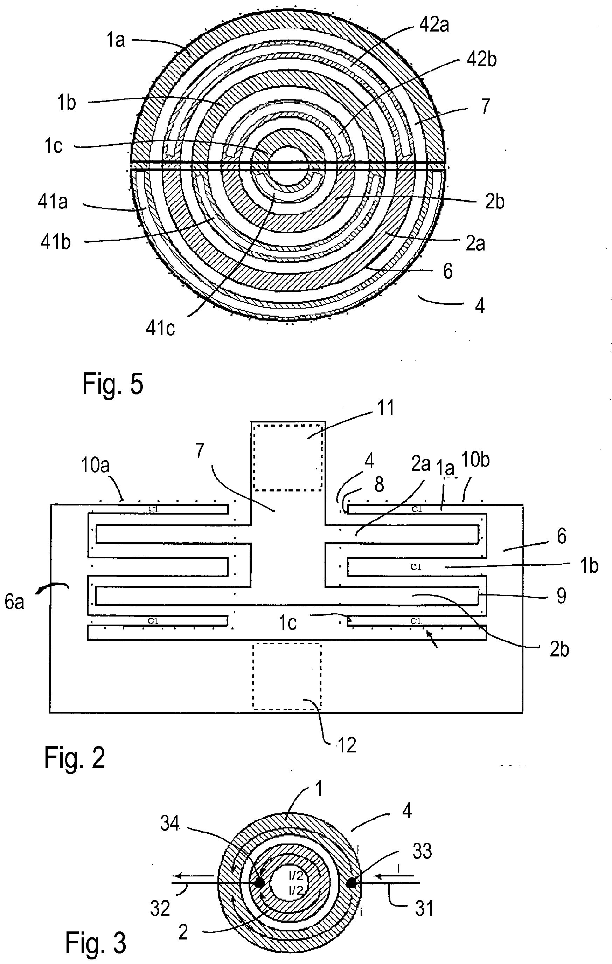

Innerhalb der Elektroden 1 und 2 sowie im Substrat 4 ergibt sich ein elektrischer Widerstand. Um diesen Widerstand zu reduzieren, werden nach dem Stand der Technik die Elektroden 1 und 2 auf ihrer Gesamtweite in mehrere schmalere Einzelbauelemente (1a, 1b, 1c, 2a, 2b) aufgeteilt, die dann über einen sog. Bus (6, 7) parallel geschaltet werden. Eine solche Anordnung ist in Figur 2 gezeigt. Hierbei gehen in einer Ebene des Substrates 4 von einem Bus 6 senkrecht zu einer Längsrichtung des Busses Einzelbauelemente 1a, 1b, 1c ab, die mit vom Bus 7 senkrecht zu dessen Längsrichtung abgehenden Einzelbauelementen 2a und 2b der Elektrode 2 ineinander greifen. Über die Breiten der Einzelbauelemente, also jene Ausdehnungen in Richtung parallel zur Längsrichtung des Busses 6 oder 7, lässt sich der nicht erwünschte Serienwiderstand sowie die maximale Stromtragfähigkeit der Elektroden 1 und 2 einstellen. In der in Figur 2 gezeigten Vorrichtung erfährt Strom, welcher in die entsprechende Elektrode über den dem zugehörigen Bus 6 oder 7 entferntesten Punkt 8 bzw. 9 eingespeist wird, den größten Serienwiderstand.

Die Busse 6 und 7 führen den Strom, welcher durch die Einzelbauelemente 2a, 2b bzw. 1a, 1b, 1c fließt, zusammen. Die Stromtragfähigkeit der Busse 6 und 7 muss jeweils so groß sein, dass sie der Summe der Stromtragfähigkeiten der Einzelbauelemente 1a, 1b, 1c bzw. 2a, 2b entspricht. Die Stromtragfähigkeit der Busse 6 und 7 kann beispielsweise durch Vergrößerung der Breite der Busse vergrößert werden. Damit vergrößern die Busse 6 und 7 jedoch die Fläche des gesamten Bauelementes, ohne mit dieser Fläche zur Einspeisung von Strom beizutragen. Der zusätzliche Platzbedarf steigt hierbei also mit der Stromstärke und der Anzahl der durch den Bus zu versorgenden Einzelbauelemente. Die punktierten Bereiche 10a, 10b stellen in Figur 2 die für aktive Strukturen verwendete Fläche dar.

An Bondflecken 11 und 12 kann das Bauelement über Bonddrähte angeschlossen werden. Auch die Bondflecken 11 und 12 müssen in ihrer Größe so eingerichtet werden, dass ihre Stromtragfähigkeit der Stromtragfähigkeit der durch sie kontaktierten Busse 6 bzw. 7 entspricht. Im Falle des Bondflecks 12 muss dessen Stromtragfähigkeit also der Summe der Stromtragfähigkeiten der Busse 6 und 6a entsprechen. Eine Vergrößerung der Bondflecken erhöht jedoch ebenfalls den Platzbedarf auf der Halbleiterscheibe, was mit erhöhten Kosten verbunden ist. Wiederum steigt der Platzbedarf außerdem mit dem Strom, der durch das anzuschließende Bauelement leitbar sein soll.

Ein weiteres Problem bei der in Figur 2 gezeigten Anordnung ist, dass, wenn die zwischen zwei Elektroden 1a, 1b, 1c und 2a, 2b angelegte Spannung im Halbleiter dessen kritische elektrische Feldstärke übersteigen lässt, ein elektrischer Durchbruch stattfindet, welcher zur Zerstörung des Bauelementes führt. Ein solcher Durchbruch setzt im Bauelement an jener Stelle an, an der die höchste Feldüberhöhung des elektrischen Feldes vorliegt. In der gezeigten Anordnung ist dies jeweils an den Enden der Bauelementstreifen 1a, 1b, 1c, 2a, 2b der Fall. Die entsprechenden Punkte sind daher in der gezeigten Anordnung besonders anfällig für eine Zerstörung durch einen elektrischen Durchbruch.

Aus DE19705791 C1, WO99/21231 A, EP0845815 A2 und US4290077 A sind außerdem Halbleiterbauelemente mit kreisringförmig geschlossenen Elektroden bekannt.

Aufgabe der vorliegenden Erfindung ist es daher, ein Halbleiterbauelement anzugeben, dessen zur Kontaktierung benötigte Fläche geringer als im Stand der Technik ist, welches außerdem geringere Serienwiderstände aufweist und darüber hinaus weniger anfällig für Zerstörung in Folge von elektrischen Durchbrüchen ist. Aufgabe der Erfindung ist es außerdem, ein Verfahren zur Herstellung eines Halbleiterbauelementes anzugeben, mit welchem die genannten Vorteile erzielbar sind.

Diese Aufgaben werden gelöst durch das Halbleiterbauelement nach Anspruch 1 und das Verfahren zur Herstellung eines Halbleiterbauelementes nach Anspruch 11. Vorteilhafte Weiterbildungen des erfindungsgemäßen Halbleiterbauelementes und des erfindungsgemäßen Verfahrens werden durch die jeweiligen abhängigen Ansprüche gegeben.

Ein erfindungsgemäßes Halbleiterbauelement weist ein Substrat auf, auf welchem mehrere längliche erste Elektroden und mehrere längliche, zweite Elektroden angeordnet sind.

Weitere entsprechend angeordnete Elektroden mit weiteren Polungen sind möglich. Das Substrat ist vorzugsweise eine leitfahige Schicht oder eine Halbleiterschicht.

Alle Elektroden, haben eine längliche Form. Das bedeutet, dass sie sich entlang einer Linie erstrecken und in einer oder zwei Richtungen senkrecht zu dieser Linie eine über die Lange der Linie im Wesentlichen konstante oder sich nur wenig ändernde Ausdehnung haben. Erfindungsgemäß sind die Elektroden nun in ihrer Längsrichtung geschlossen, d.h. dass die genannte Linie, entlang derer sich die Elektroden erstrecken, für jede Elektrode eine geschlossene Linie ist. Geschlossen bedeutet hierbei, dass die Linie bzw. die Elektroden entlang ihrer Längsrichtung in sich selbst übergehen, also keinen Anfang und kein Ende haben. Die Elektroden sind also so gestaltet, dass ihre Flächen einen freien nicht von der entsprechenden Elektrode überdeckten Bereich umschließen.

Die Elektroden können jeweils in der genannten Weise ringförmig, kreisförmig, elliptisch, rechteckig, quadratisch, dreieckig, vieleckig oder in anderer Weise geschlossen sein. Hierbei verläuft dann die Elektrode entlang den Kanten der entsprechenden Form.

Die Elektroden sind vorzugsweise in ihrer Längsrichtung parallel zum Substrat und parallel zueinander angeordnet. Zwischen den Elektroden ist bevorzugt eine Spannung so anlegbar, dass die zumindest eine erste Elektrode eine erste Polarität oder Polung hat und die zumindest zweite Elektrode eine zweite Polarität oder Polung hat, wobei die Elektroden zumindest zwei verschiedene Funktionen im Halbleiterbauelement haben. Parallelität bedeutet hier, dass der kürzeste Abstand der zueinander parallelen Objekte konstant und/oder auf der gesamten Ausdehnung oder der Länge der gleiche ist. Als Polarität oder Polung wird hier vorzugsweise das Vorzeichen des Potentials an der entsprechenden Elektrode oder auch das relative Potential der Elektroden zueinander verstanden. Zwei Elektroden, deren Potential das gleiche Vorzeichen, aber unterschiedliche Betrage hat, haben also in diesem Sinne unterschiedliche Polaritäten. Der Begriff Funktion wird hier analog verwendet. Unter Funktion wird auch die Funktion der entsprechenden Elektrode im Bauelement verstanden. Ist beispielsweise das Bauelement ein Transistor, so können die Funktionen der Elektroden beispielsweise Drain, Source und Gate oder Emitter, Kollektor und Basis sein. Im Falle einer Diode kann z.B. für die eine Elektrode die Polarität oder Funktion der Pluspol und für die andere der Minuspol sein. Für andere Bauelemente gilt Entsprechendes.

Die Elektroden können u.a. zu einem Halbleiter nicht sperrend als Ohm-Kontakt oder sperrend als Schottky-Kontakt ausgebildet sein.

Es ist bevorzugt, wenn die Elektroden in einer gemeinsamen Ebene angeordnet sind. Bevorzugt ist auch, wenn das Substrat im Wesentlichen flächig, vorzugsweise in einer Ebene, ausgedehnt ist. Das bedeutet, dass zwei einander gegenüber liegend Oberflächen des Substrates deutlich größer sind als die anderen Oberflächen des Substrates. Die Elektroden erstrecken sich dann vorzugsweise in einer oder mehreren Ebenen, die parallel zu jenen Ebenen liegen, in welchen sich das Substrat flächig ausdehnt.

Die Elektroden sind konzentrisch um einen gemeinsamen Mittelpunkt angeordnet.

Durch die erfindungsgemäß geschlossene Anordnung der Elektroden ist es möglich, diese an einem beliebigen Punkt zu kontaktieren und dabei den unerwünschten Serienwiderstand innerhalb der Elektrode gegenüber einer nicht geschlossenen Anordnung zu halbieren. Der Widerstand wird dadurch halbiert, dass es von jedem Punkt der Elektrode zu einer Kontaktierung nach außen, beispielsweise über einen Bus, zwei Wege entlang der Elektrode gibt, die zueinander parallel geschaltet sind. Die Leitwerte der beiden Wege addieren sich also zu einem gemeinsamen Leitwert, der größer ist als der Leitwert der einzelnen Wege. Der Leitwert ist hierbei der inverse Widerstand.

Die ersten Elektroden sind durch einen gemeinsamen Bus verbunden und die zweiten Elektroden sind durch einen gemeinsamen Bus verbunden. Eventuelle weitere Elektroden mit weiteren Polaritäten können analog durch weitere Busse verbunden sein.

Vorzugsweise ist zumindest einer der Busse in einer Ebene angeordnet, die parallel zu jener Ebene liegt, in welcher das Substrat flächig ausgedehnt ist und in welcher weder das Substrat noch die Elektroden angeordnet sind. Besonders bevorzugt ist zumindest einer der Busse, vorzugsweise alle Busse, auf einer dem Substrat abgewandten Seite der Elektroden angeordnet. In diesem Fall können also auf dem Substrat zunächst die Elektroden in einer gemeinsamen Ebene angeordnet sein und über den Elektroden dann der oder die Busse.

Vorteilhafterweise sind der oder die Busse nicht unmittelbar auf den Elektroden angeordnet, sondern von diesen beabstandet. Hierbei ist vorzugsweise zwischen den Bussen und den Elektroden zumindest eine Isolationsschicht angeordnet. Es ist dann bevorzugt, wenn zwischen zumindest einem der Busse und den durch den entsprechenden Bus verbundenen Elektroden zumindest ein Via-Kontakt angeordnet ist, über welchen die Elektroden mit dem sie kontaktierenden Bus elektrisch verbunden werden. Der Via-Kontakt verläuft also über den Abstand zwischen den Elektroden und den Bussen.

Die Via-Kontakte können sich insbesondere durch Löcher in der Isolationsschicht erstrecken. Solche Löcher bzw. Öffnungen können dazu mit einem leitfähigen Material, wie z.B. Metall, gefüllt sein.

Die Isolationsschicht kann ein Dielektrikum und/oder Polymere aufweisen oder daraus bestehen.

Die Via-Kontakte können auf verschiedenste Weise ausgestaltet sein. Sie können länglich sein und sie können u.a. Quader- oder Zylinderform haben.

Für bestimmte Anwendungen kann die Struktur der Isolationsschichten und Via-Kontakte auch komplizierter sein.

Es kann z.B. auf die Elektroden zunächst eine Isolationsschicht aufgebracht sein, welche Öffnungen über den Elektroden aufweist. Auf dieser Isolationsschicht können eine oder mehrere Metallschichten aufgebracht sein, welche sich auch in die Öffnungen erstreckt und hierdurch die Elektroden kontaktiert. Hier kann es für jede Polarität eine getrennte Metallschicht oder einen getrennten Bereich der Metallschicht geben.

Für mehr als zwei Polaritäten können entsprechend auf den Metallschichten zumindest bereichsweise zumindest eine weitere Isolationsschicht sowie zumindest eine weitere Metallschicht, welche getrennte Bereiche für unterschiedliche Polaritäten aufweist, entsprechend dem oben für die anderen Schichten Beschriebenen aufgebracht sein.

Werden Elektroden mehrerer Polungen oder Polaritäten über mehrere Busse jeweils verbunden, so können die Busse in unterschiedlichen oder einer gemeinsamen Ebene angeordnet sein. Da die Elektroden länglich ausgedehnt sind, ist es möglich, mehrere Busse so anzuordnen, dass alle Elektroden abschnittsweise unter jedem Bus verlaufen, wobei die Via-Kontakte aber nur zwischen einem gegebenen Bus und den durch diesen kontaktierten Elektroden angeordnet ist. Die anderen Elektroden verlaufen ohne elektrischen Kontakt zu diesem Bus zwischen dem Substrat und dem Bus entlang. Vorzugsweise ist zwischen den Elektroden und jenen Bussen, die diese Elektroden nicht kontaktieren, zumindest eine Isolationsschicht angeordnet.

Es ist, insbesondere in der vorgenannten Konstellation, möglich, dass die Busse in der Ebene ihrer Anordnung flächig ausgedehnt sind. Sie können sich hierbei flächig über einen Teil der Fläche des Substrates erstrecken. Vorteilhaft ist es dabei, die Fläche der Busse möglichst groß zu machen. Es ist daher bevorzugt, wenn die Busse gemeinsam die Oberfläche des Substrates zu großen Teilen vorzugsweise im Wesentlichen vollständig überdecken.

Besonders bevorzugt ist es, die Fläche eines oder mehrerer Versorgungsbuse als Bondfleck zu verwenden, welcher dazu dient, das Halbleiterbauelement über Bonddrähte anzuschließen. Hierdurch kann die Kontaktierung mittels Bonddrähten erfolgen, ohne dass hierfür zusätzliche Halbleiterfläche benötigt wird.

Durch die beschriebene Kontaktierung der Elektroden mittels Bussen, die vertikal über dem Halbleiterbauelement und den Elektroden angeordnet sind, kann die durch das aktive Bauelement aktive Fläche doppelt genutzt werden. Der Versorgungsbus benötigt also keine zusätzliche Halbleiterscheibenfläche.

Bevorzugterweise verlaufen die Via-Kontakte länglich parallel zu jenen Elektroden, welche durch sie mit einem Bus verbunden sind. Die Via-Kontakte können hierbei entlang der Elektroden in jenem Bereich verlaufen, in welchem die Elektroden unterhalb der sie kontaktierenden Busse verlaufen.

Das Halbleiterbauelement weist vorzugsweise zumindest einen Transistor und/oder eine Diode auf, oder ist ein Transistor oder eine Diode. Ein solcher Transistor ist vorzugsweise ein Feldeffekt-Transistor.

Die ersten und die zweiten Elektroden können voneinander beabstandet angeordnet sein.

Zumindest einer der Busse kann flächig mit zum Substrat paralleler Fläche ausgebildet sein.

Zumindest eine der Elektroden und/oder der Via-Kontakte und/oder der Busse kann ein Metall aufweisen oder daraus bestehen, vorzugsweise zumindest zwei Metallschichten.

Es kann vorzugsweise zumindest ein Bondfleck vorgesehen sein, welcher auf oder an zumindest einem der Busse angeordnet ist und über welchen der entsprechende Bus kontaktierbar ist.

Via-Kontakte können vorzugsweise länglich mit zu den ersten (1a, 1b, 1c) und/oder zweiten (2a, 2b) Elektroden paralleler Längsrichtung ausgebildet sein.

Als Halbleitermaterialien kommen unter anderem bevorzugt solche in frage, die zumindest ein Nitrid eines Hauptgruppe-III-Elementes enthalten oder daraus bestehen. Diese Materialien sind also unter anderem GaN, AlN, InN, GaAlN, GaInN, AlInN und AlInGaN. Solche können besonders resistent gegen hohe Temperaturen, vorzugsweise größer oder gleich 100 °C, besonders bevorzugt größer oder gleich 300 °C, besonders bevorzugt größer oder gleich 500 °C, besonders bevorzugt größer oder gleich 700 °C sein.

Im Folgenden soll die Erfindung anhand einiger Figuren beispielhaft erläutert werden. Die in den Figuren gezeigten Merkmale können jeweils auch einzeln in der Erfindung realisiert sein.

Es zeigt
- Figur 1: einen Schnitt durch ein laterales Bauelement nach dem Stand der Technik,
- Figur 2: ein Halbleiterbauelement nach dem Stand der Technik,
- Figur 3: ein Halbleiterbauelement mit kreisringförmig geschlossenen Elektroden
- Figur 4: einen Schnitt durch ein Halbleiterbauelement entsprechend der vorliegenden Erfindung, und
- Figur 5: eine Aufsicht auf ein erfindungsgemäßes Halbleiterbauelement.

Figur 3 zeigt eine Aufsicht auf ein Halbleiterbauelement mit einer ersten Elektrode 1 und einer zweiten Elektrode 2, die auf einem gemeinsamen Substrat 4 angeordnet sind. Die Elektroden 1 und 2 sind länglich, kreisringförmig geschlossen und konzentrisch um einen gemeinsamen Mittelpunkt angeordnet. In ihrer Längsrichtung sind die erste und die zweite Elektrode geschlossen. Die Elektroden 1 und 2 verlaufen parallel zur Oberfläche des Substrates 4, auf dem sie angeordnet sind in einer gemeinsamen Ebene, sowie beabstandet voneinander und parallel zueinander. Die Elektrode 1 ist hierbei durch einen Kontakt 31 an einem Punkt 33 kontaktiert. Die Elektrode 2 ist über einen Kontakt 32 an einem Punkt 34 kontaktiert. Bei Anlegen einer Spannung hat dann die erste Elektrode eine erste Polarität und die zweite Elektrode eine zweite, von der ersten verschiedene Polarität. Wird nun ein Strom beispielsweise in die Elektrode 1 an jenem dem Kontaktierungspunkt 33 bezüglich des Mittelpunktes gegenüber liegenden Punkt der Elektrode eingespeist, so kann dieser Strom entlang beider Halbkreise der Elektrode zum Kontaktierungspunkt 33 fließen. Ein solcher Strom erfährt also den halben Widerstand gegenüber einem Strom, der nur durch einen Halbkreis der Elektrode fließen würde. Entsprechendes gilt für die Elektrode 2. Der unerwünschte Serienwiderstand wird also durch die geschlossene Anordnung der Elektroden 1 und 2 halbiert.

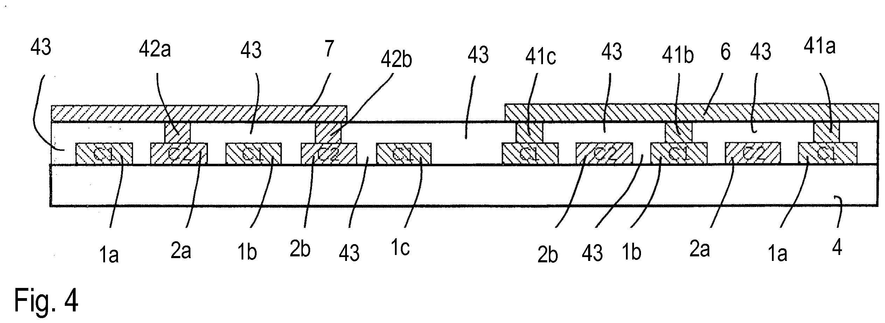

Figur 4 zeigt einen Schnitt durch ein erfindungsgemäßes Halbleiterbauelement mit einer Vielzahl von Elektroden 1a, 1b, 1c, welche beim Anlegen einer Spannung eine erste Polarität haben, sowie einer Vielzahl von Elektroden 2a, 2b, welche bei Anlegen einer Spannung eine zweite Polarität haben. Die Elektroden sind in einer Ebene auf einem gemeinsamen Substrat 4 angeordnet. Auf jener dem Substrat 4 abgewandten Seite werden die Elektroden 1a, 1b und 1c durch einen Bus 6 kontaktiert. Die Elektroden 2a und 2b werden durch einen Bus 7 kontaktiert, welcher in einer Ebene angeordnet ist, in der die Elektroden 1 und 2 nicht angeordnet sind. Diese Ebene ist parallel zum Substrat 4 und der Ebene der Elektroden 1 und 2. Die Kontakte 6 und 7 sind hier in einer Ebene angeordnet. Zu beachten ist, dass das gezeigte Bauelement in der Ebene senkrecht zur Zeichenebene, wie in Figur 5 gezeigt, ringförmig geschlossen ist, so dass auch die unter dem Bus 7 angeordneten Teile der Elektroden 1a und 1b durch den Bus 6 kontaktiert werden.

Die Busse 6 und 7 sind nicht unmittelbar auf den Elektroden 1a, 1b, 1c und 2a, 2b angeordnet. Vielmehr ist zwischen den Elektroden und den Bussen 6 und 7 eine Isolationsschicht 43 angeordnet. Die elektrische Verbindung zwischen den Elektroden 2a und 2b mit dem Bus 7 wird hierbei durch die Isolationsschicht 43 durchstoßende Via-Kontakte 42a bzw. 42b erzielt. Entsprechend werden die Elektroden 1a, 1b und 1c mit dem Bus 6 durch Via-Kontakte 41a, 41b bzw. 41c kontaktiert. Die Via-Kontakte 41a, 41b, 41c und 42a, 42b können hierbei in Richtung senkrecht zur Zeichenebene länglich ausgebildet sein.

Das Isolationsmaterial 43 ist jeweils zwischen den Elektroden 1a, 1b, 1c und den benachbarten Elektroden 2a, 2b angeordnet. Darüber hinaus ist das Isolationsmaterial 43 zwischen der Ebene der Elektroden 1, 2 und den Bussen 6, 7 angeordnet, die jedoch von den Via-Kontakten 41a, 41b, 41c, 42a, 42b durchstoßen wird.

Figur 5 zeigt eine Aufsicht auf ein Halbleiterbauelement, wie dies in Figur 4 gezeigt ist. Die Elektroden 1a, 1b und 1c sowie 2a, 2b sind hierbei ringförmig geschlossen konzentrisch angeordnet. Die Busse 6 und 7 sind als im Wesentlichen halbe Kreisflächen mit zum Substrat paralleler Ausdehnung ausgestaltet, welche die durch die Elektroden abgedeckte, kreisförmige Oberfläche des Substrates 4 bis auf einen schmalen Spalt zur Isolierung vollständig überdecken. Die flächigen Busse 6 und 7 dienen hier außerdem als Bondflecken zur Kontaktierung des Halbleiterbauelementes mittels Bonddrähten. Die Elektroden 1a, 1b, 1c sind hierbei mit dem Bus 6 über längliche, parallel zu den Elektroden verlaufende Via-Kontakte 41a, 41b, 41c verbunden. Die Elektroden 2a, 2b sind mit dem Bus 7 über längliche, parallel zu den Elektroden verlaufende Via-Kontakte 42a, 42b verbunden. Auf oder an den Bussen 6 und 7 kann jeweils ein Bondfleck 11 bzw. 12 angeordnet sein. Das Substrat 4, die Elektroden 1 und 2 und/oder die Via-Kontakte 41a, 41b, 41c, 42a, 42b können Nitrid eines Hauptgruppe-III-Elementes aufweisen oder daraus bestehen.

## Patentansprüche

1. Halbleiterbauelement mit einem Substrat (4), mehreren auf dem Substrat angeordneten länglichen ersten Elektroden (1a, 1b, 1c) und mehreren auf dem Substrat angeordneten länglichen zweiten Elektroden (2a, 2b),
wobei die ersten Elektroden eine erste Funktion haben und die zweiten Elektroden eine zweite Funktion haben, wobei die ersten und die zweiten Elektroden jeweils in ihrer Längsrichtung geschlossen sind und wobei die ersten Elektroden (1a, 1b, 1c) und die zweiten Elektroden (2a, 2b) konzentrisch um einen gemeinsamen Mittelpunkt angeordnet sind,
wobei die ersten Elektroden mit der ersten Funktion durch einen gemeinsamen Bus verbunden sind und die zweiten Elektroden mit der zweiten Funktion mit einem weiteren Bus verbunden sind.

2. Halbleiterbauelement nach dem vorhergehenden Anspruch,
**dadurch gekennzeichnet, dass** die ersten Elektroden (1a, 1b, 1c) und die zweiten Elektroden (2a, 2b) parallel zu einer Oberfläche des Substrates (4) auf welcher sie angeordnet sind, verlaufen und/oder dass die ersten (1a, 1b, 1c) und die zweiten (2a, 2b) Elektroden in einer gemeinsamen Ebene angeordnet sind.

3. Halbleiterbauelement nach einem der beiden vorhergehenden Ansprüche,
**dadurch gekennzeichnet, dass** zwischen den ersten (1a, 1b, 1c) und den zweiten (2a, 2b) Elektroden eine Spannung so anlegbar ist, dass die ersten Elektroden eine erste Polarität und die zweiten Elektroden eine zweite, von der ersten Polarität verschiedene Polarität, haben.

4. Halbleiterbauelement nach einem der vorhergehenden Ansprüche,
**dadurch gekennzeichnet, dass** die ersten (1a, 1b, 1c) und die zweiten Elektroden (2a, 2b) jeweils in ihrer Längsrichtung ringförmig, kreisförmig, elliptisch, rechteckig, quadratisch, dreieckig oder vieleckig geschlossen sind.

5. Halbleiterbauelement nach einem der vorhergehenden Ansprüche, **dadurch gekennzeichnet, dass** zumindest einer der Busse (6, 7) in einer Ebene parallel zu einer Ebene, in welcher das Substrat (4) flächig ausgedehnt ist und in welcher weder das Substrat noch die Elektroden (1a, 1b, 1c, 2a, 2b) angeordnet sind, vorzugsweise auf einer dem Substrat abgewandten Seite der Elektroden, angeordnet ist.

6. Halbleiterbauelement nach einem der vorhergehenden Ansprüche, **dadurch gekennzeichnet, dass** zwischen zumindest einem der Busse (6, 7) und den durch den entsprechenden Bus verbundenen Elektroden (1a, 1b, 1c, 2a, 2b) zumindest ein Via-Kontakt (41a, 41b, 41c, 42a, 42b) angeordnet ist, über welchen die Elektroden mit dem entsprechenden Bus elektrisch kontaktiert sind und **gekennzeichnet durch** zumindest eine Isolationsschicht (43), welche dort zwischen den Bussen (6, 7) und den Elektroden (1a, 1b, 1c, 2a, 2b) angeordnet ist, wo keine Via-Kontakte (41a, 41b, 41c, 42a, 42b) angeordnet sind.

7. Halbleiterbauelement nach einem der vorhergehenden Ansprüche, **dadurch gekennzeichnet, dass** das Substrat (4) kreisflächenförmig ist, dass die ersten (1a, 1b, 1c) und die zweiten (2a, 2b) Elektroden kreisringförmig konzentrisch um einen Mittelpunkt des Substrates angeordnet sind, und dass der erste (6) und der zweite (7) Bus als Sektoren, vorzugsweise als Halbe, einer Kreisfläche ausgestaltet sind.

8. Halbleiterbauelement nach einem der vorhergehenden Ansprüche, **gekennzeichnet durch** eine oder mehrere weitere Elektroden mit einer oder mehreren weiteren Funktionen.

9. Halbleiterbauelement nach einem der vorhergehenden Ansprüche, **dadurch gekennzeichnet, dass** das Substrat (4) und/oder zumindest eine der Via-Kontaktierungen (41a, 41b, 41c, 42a, 42b) ein Nitrid eines Hauptgruppe-III-Elementes aufweist oder daraus besteht, vorzugsweise dass das Substrat und/oder zumindest eine der Via-Kontaktierungen GaN, AIN, InN, AIGaN, InGaN und/oder AlGaInN aufweist oder daraus besteht.

10. Halbleiterbauelement nach einem der vorhergehenden Ansprüche, **dadurch gekennzeichnet, dass** das Halbleiterbauelement zumindest einen Transistor und/oder zumindest eine Diode aufweist oder ist.

11. Verfahren zur Herstellung eines Halbleiterbauelements mit einem Substrat (4), wobei auf dem Substrat mehrere längliche erste Elektroden (1a, 1b, 1c) und mehrere längliche zweite Elektroden (2a, 2b) angeordnet werden,
wobei die ersten Elektroden eine erste Funktion haben und die zweiten Elektroden eine zweite Funktion haben, wobei die ersten und die zweiten Elektroden jeweils in ihrer Längsrichtung geschlossen ausgestaltet werden und wobei die ersten Elektroden und die zweiten Elektroden konzentrisch um einen gemeinsamen Mittelpunkt angeordnet werden,
wobei die ersten Elektroden mit der ersten Funktion durch einen gemeinsamen Bus verbunden sind und die zweiten Elektroden mit der zweiten Funktion mit einem weiteren Bus verbunden sind.

12. Verfahren nach dem vorhergehenden Anspruch 11, **dadurch gekennzeichnet, dass** ein Halbleiterbauelement nach einem der Ansprüche 2 bis 10 hergestellt wird.

13. Verwendung eines Halbleiterbauelementes nach einem der Ansprüche 1 bis 10 als Hochtemperaturbauelement.

## Claims

1. A semiconductor device comprising a substrate (4) a plurality of elongate first electrodes (1a, 1b, 1c) arranged on the substrate and a plurality of elongate second electrodes (2a, 2b) arranged on the substrate,
wherein the first electrodes have a first function and the second electrodes have a second function,
wherein the first and second electrodes are each closed in their longitudinal direction, and wherein the first electrodes (1a, 1b, 1c) and the second electrodes (2a, 2b) are concentrically arranged around a common center,
wherein the first electrodes are connected to the first function by a common bus and the second electrodes are connected to the second function by a further bus.

2. The semiconductor device according to the preceding claim,
**characterized in that** the first electrodes (1a, 1b, 1c) and the second electrodes (2a, 2b) run in parallel to a surface of the substrate (4) on which they are arranged and/or **characterized in that** the first (1a, 1b, 1c) and the second (2a, 2b) electrodes are arranged in a common layer.

3. The semiconductor device according to one of the two preceding claims,
**characterized in that** a voltage can be applied between the first (1a, 1b, 1c) and the second (2a, 2b) electrodes such that the first electrodes have a first polarity and the second electrodes have a second polarity which is different from the first polarity.

4. The semiconductor device according to one of the preceding claims, **characterized in that** the first (1a, 1b, 1c) and the second electrodes (2a, 2b) are each closed in their longitudinal direction annular, circular, elliptical, rectangular, square, triangular or polygonal.

5. The semiconductor device according to one of the preceding claims,
**characterized in that** at least one of the buses (6, 7) is arranged in a layer parallel to a layer in which the substrate (4) extends and in which neither the substrate nor the electrodes (1a, 1b, 1c, 2a, 2b) are arranged, preferably on a side of the electrodes facing away from the substrate.

6. The semiconductor device according to one of the preceding claims,
**characterized in that** at least one via contact (41a, 41b, 41c, 42a, 42b) is arranged between at least one of the buses (6, 7) and the electrodes (1a, 1b, 1c, 2a, 2b), which are connected by the corresponding bus, through which the electrodes are electrically contacted with the corresponding bus, and **characterized in that** at least one insulating layer (43) which is arranged between the buses (6, 7) and the electrodes (1a, 1b, 1c, 2a, 2b), where no via contacts (41a, 41b, 41c, 42a, 42b) are arranged.

7. The semiconductor device according to one of the preceding claims,
**characterized in that** the substrate (4) is circular shaped, and **in that** the first (1a, 1b, 1c) and the second (2a, 2b) electrodes are arranged annularly concentrically around a centre of the substrate, and **in that** the first (6) and the second (7) bus are formed as sectors, preferably as halves, of a circular area.

8. The semiconductor device according to one of the preceding claims,
**characterized by** one or more further electrodes having one or more further functions.

9. The semiconductor device according to one of the preceding claims,
**characterized in that** the substrate (4) and/or at least one of the via contacts (41a, 41b, 41c, 42a, 42b) comprises or consists of a nitride of a main group-III-element, preferably **characterized in that** the substrate and/or at least one of the via contacts comprises or consists of GaN. AlN, InN. AlGaN, InGaN and/or AlGaInN.

10. The semiconductor device according to one of the preceding claims,
**characterized in that** the semiconductor device comprises or is at least one transistor and/or at least one diode.

11. A method for producing a semiconductor device comprising a substrate (4),
wherein a plurality of elongate first electrodes (1a, 1b, 1c) and a plurality of elongate second electrodes (2a, 2b) are arranged on the substrate,
wherein the first electrodes have a first function and the second electrodes have a second function,
wherein the first and second electrodes are each configured to be closed in their longitudinal direction, and wherein the first electrodes and the second electrodes are concentrically arranged around a common center,
wherein the first electrodes are connected to the first function by a common bus and the second electrodes are connected to the second function by a further bus.

12. A method according to the preceding claim 11, **characterized in that** a semiconductor device is produced according to any one of claims 2 to 11.

13. Use of a semiconductor device according to one of claims 1 to 10 as a high-temperature device.

## Revendications

1. Composant semiconducteur comprenant un substrat (4), plusieurs premières électrodes (1a, 1b, 1c) allongées disposées sur le substrat et plusieurs deuxièmes électrodes (2a, 2b) allongées disposées sur le substrat,
les premières électrodes ayant une première fonction et les deuxièmes électrodes ayant une deuxième fonction,
les premières et les deuxièmes électrodes étant respectivement fermées dans leur direction longitudinale et les premières électrodes (1a, 1b, 1c) et les deuxièmes électrodes (2a, 2b) étant disposées de manière concentrique autour d'un point central commun,
les premières électrodes ayant la première fonction étant reliées par un bus commun et les deuxièmes électrodes ayant la deuxième fonction étant reliées par un bus supplémentaire.

2. Composant semiconducteur selon la revendication précédente, **caractérisé en ce que** les premières électrodes (1a, 1b, 1c) et les deuxièmes électrodes (2a, 2b) s'étendent parallèlement à une surface du substrat (4) sur laquelle elles sont disposées et/ou **en ce que** les premières électrodes (1a, 1b, 1c) et les deuxièmes électrodes (2a, 2b) sont disposées dans un plan commun.

3. Composant semiconducteur selon l'une des deux revendications précédentes, **caractérisé en ce qu'**une tension peut être appliquée entre les premières électrodes (1a, 1b, 1c) et les deuxièmes électrodes (2a, 2b) de telle sorte que les premières électrodes possèdent une première polarité et les deuxièmes électrodes une deuxième polarité, différente de la première polarité.

4. Composant semiconducteur selon l'une des revendications précédentes, **caractérisé en ce que** les premières électrodes (1a, 1b, 1c) et les deuxièmes électrodes (2a, 2b) sont respectivement fermées dans leur direction longitudinale en forme d'anneau, en forme de cercle, de manière elliptique, rectangulaire, carrée, triangulaire ou polygonale.

5. Composant semiconducteur selon l'une des revendications précédentes, **caractérisé en ce qu'**au moins l'un des bus (6, 7) est disposé dans un plan parallèle à un plan dans lequel le substrat (4) s'étend à plat et dans lequel ne sont disposés ni le substrat ni les électrodes (1a, 1b, 1c, 2a, 2b), de préférence sur un côté des électrodes à l'opposé du substrat.

6. Composant semiconducteur selon l'une des revendications précédentes, **caractérisé en ce qu'**entre au moins l'un des bus (6, 7) et les électrodes (1a, 1b, 1c, 2a, 2b) reliées par le bus correspondant est disposé au moins un contact à trou d'interconnexion (41a, 41b, 41c, 42a, 42b), par le biais duquel les électrodes sont mises en contact électrique avec le bus correspondant et **caractérisé par** au moins une couche isolante (43) qui est disposée entre les bus (6, 7) et les électrodes (1a, 1b, 1c, 2a, 2b) là où n'est disposé aucun contact à trou d'interconnexion (41a, 41b, 41c, 42a, 42b).

7. Composant semiconducteur selon l'une des revendications précédentes, **caractérisé en ce que** le substrat (4) est en forme de surface circulaire, **en ce que** les premières (1a, Ib, 1c) et les deuxièmes (2a, 2b) électrodes sont disposées de manière concentrique en forme de surface circulaire autour d'un point central du substrat, et **en ce que** le premier (6) et le deuxième (7) bus sont configurés sous la forme de secteurs, de préférence sous la forme de la moitié d'une surface circulaire.

8. Composant semiconducteur selon l'une des revendications précédentes, **caractérisé par** une ou plusieurs électrodes supplémentaires ayant une ou plusieurs fonctions supplémentaires.

9. Composant semiconducteur selon l'une des revendications précédentes, **caractérisé en ce que** le substrat (4) et/ou au moins l'un des contacts à trou d'interconnexion (41a, 41b, 41c, 42a, 42b) possède un nitrure d'un élément du groupe principal III ou se compose de celui-ci, de préférence **en ce que** le substrat et/ou au moins l'un des contacts à trou d'interconnexion possède du GaN, AlN, InN, AlGaN, InGaN et/ou AlGalnN ou en est constitué.

10. Composant semiconducteur selon l'une des revendications précédentes, **caractérisé en ce que** le composant semiconducteur possède ou est au moins un transistor et/ou au moins une diode.

11. Procédé de fabrication d'un composant semiconducteur comprenant un substrat (4), plusieurs premières électrodes (1a, 1b, 1c) allongées étant disposées sur le substrat et plusieurs deuxièmes électrodes (2a, 2b) allongées étant disposées sur le substrat,
les premières électrodes ayant une première fonction et les deuxièmes électrodes ayant une deuxième fonction,
les premières et les deuxièmes électrodes étant respectivement configurées fermées dans leur direction longitudinale et les premières électrodes et les deuxièmes électrodes étant disposées de manière concentrique autour d'un point central commun,
les premières électrodes ayant la première fonction étant reliées par un bus commun et les deuxièmes électrodes ayant la deuxième fonction étant reliées par un bus supplémentaire.

12. Procédé selon la revendication précédente 11, **caractérisé en ce qu'**un composant semiconducteur selon l'une des revendications 2 à 11 est fabriqué.

13. Utilisation d'un composant semiconducteur selon l'une des revendications 1 à 10 en tant que composant pour haute température.
